Europäisches Patentamt

European Patent Office

Office européen des brevets

(11) Publication number: **0 429 810 A2**

# EUROPEAN PATENT APPLICATION

(21) Application number: 90119396.1

(22) Date of filing: 10.10.90

(51) Int. Cl.⁵: **H01L 31/0232**, G01J 1/04, G01J 1/42, G01J 1/58

(30) Priority: 22.11.89 US 441125

(43) Date of publication of application:
05.06.91 Bulletin 91/23

(84) Designated Contracting States:
DE FR GB IT NL Bulletin 00/1

(71) Applicant: TEXAS INSTRUMENTS
INCORPORATED
13500 North Central Expressway
Dallas Texas 75265(US)

(72) Inventor: Masten, Billy R.
1312 5th Street
Shallowater, Texas 79363(US)

(74) Representative: Leiser, Gottfried, Dipl.-Ing. et
al
Patentanwälte Prinz, Leiser, Bunke & Partner
Manzingerweg 7
W-8000 München 60(DE)

(54) A method and apparatus for collecting electromagnetic radiation.

(57) Apparatus is provided for collection and concentration of incident electromagnetic radiation traveling in a medium. A dye (14) absorptive of the wavelength of the electromagnetic radiation (16) is suspended in a non-opaque solid (12). This solid/dye suspension is exposed to the incoming electromagnetic radiation (16) through an entrance surface (24). The dye (14) absorbs the electromagnetic radiation (16) and then re-emits a second radiation (15) throughout the solid (12). Since the re-emission is uniform, if an exit surface (26) is made small compared to the entrance surface (24), a power density increase is realized at exit surface (26). A receptor (20) sensitive to the wavelength of radiation (18) re-emitted from the dye (14) is then used to receive the electromagnetic radiation at an increased power level. To increase the gain, one surface (30) of the solid (12) can be mirrored such that additional energy, which would normally exit that surface (30), is now redirected back into the solid, a portion of said energy exiting surface (26) adjacent to the receptor (20) to provide the additional power density increase.

EP 0 429 810 A2

# A METHOD AND APPARATUS FOR COLLECTING ELECTROMAGNETIC RADIATION

## TECHNICAL FIELD OF THE INVENTION

The present invention relates in general to antennas and more particularly to a method and apparatus for collecting and concentrating electromagnetic radiation.

## BACKGROUND OF THE INVENTION

One means of transferring power and data between remote terminals is by the transmission of electromagnetic radiation in the medium between them. The efficiency of such a system is dependent on the ability of the receiving terminal to discern the incoming signal from background noise, and from signals from extraneous sources. This sensitivity of the receiver is greatly dependent on the signal power reaching the input. Signal power itself is dependent on the separation between the transmitting and receiving terminals, with the power decreasing directly with the square of the separation distance. Thus, to either improve sensitivity for a fixed distance or increase the range between transmitter and receiver, it is necessary to provide increased signal strength at the receiver input.

In the infrared, optical and ultraviolet portions of the electromagnetic spectrum, receivers using photosensitive semiconductor sensors may be employed. One means of increasing sensitivity is to increase the size of the sensors. This has significant disadvantages. As an initial matter, increasing the size of the sensor prohibitively increases its cost. More importantly, in addition to increasing the signal strength provided to the receiver, a larger sensor increases received noise power and internally generated noise, which greatly limits the improvement in sensitivity. The increased noise is a direct result of the increased surface area of the semiconductor sensor; the increased surface area increases dark current, itself based on the probability of electrons jumping across a pn junction. Therefore, when a semiconductor sensor is used, a need has arisen for a method and apparatus for collecting and concentrating incoming signals without increasing the sensor size.

## SUMMARY OF THE INVENTION

The present invention comprises an apparatus for collecting and concentrating electromagnetic radiation transmitted through a medium. Dye responsive to exposure to the wavelength of the electromagnetic radiation is suspended in a solid non-opaque to that wavelength. The solid has an index of refraction different from that of the medium in which the electromagnetic radiation is traveling. One or more surfaces of the solid is exposed to the electromagnetic radiation which is then absorbed by the dye. In response, the dye re-emits a second radiation. Through direct emission from the dye and redirection of re-emitted radiation striking the surfaces of the solid below the critical angle, the amount of radiation exiting each surface, regardless of size, is uniform. An exit surface of the solid is formed for transmitting the re-emitted radiation out of the solid. Since the dye uniformly transmits through all surfaces of the solid, making the surface area of this exit surface small in comparison to the other surfaces results in a concentration of re-emitted radiation transmitted through that surface.

Additional electromagnetic radiation can be transmitted through this exit surface by creating at least one mirrored surface on the solid for redirecting electromagnetic radiation which would normally escape through that surface back through the interior of the solid and out through the exit surface. A receptor, sensitive to the wavelength of the re-emitted radiation, is mounted adjacent to the exit surface for receiving a predetermined portion of the re-emitted radiation.

The concentration of the re-emitted radiation along the smaller exist surface provides an important advantage. When the exit face is small, the surface area of the receptor can also be small. The small surface area of the receptor minimizes the received noise power since noise is directly proportional to the aperture of the receptor. An additional advantage is realized in that the cost of the receptor is proportional to its size, thus, building a smaller sensor is correspondingly more economical.

## BRIEF DESCRIPTION OF THE DRAWINGS

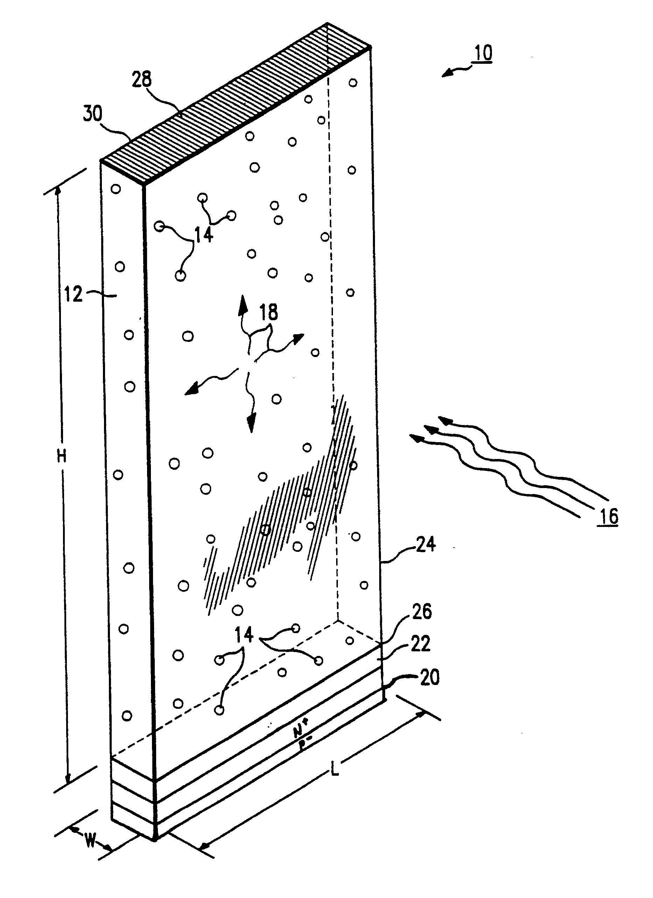

Further aspects of the invention and their advantages will be more completely understood by studying the detailed description below taken in conjunction with the appended drawing in which:

The FIGURE is an isometric schematic diagram of an electromagnetic radiation antenna according to the invention, certain dimensions thereof being exaggerated for the purpose of clarity.

DETAILED DESCRIPTION OF THE INVENTION

Referring to the FIGURE, an electromagnetic radiation antenna is indicated generally at 10. The preferred embodiment of the antenna comprises a solid 12 in which a dye 14, indicated schematically in the FIGURE by a plurality of dots, is suspended. Dye 14 absorbs electromagnetic radiation of a predetermined wavelength, indicated in the FIGURE at 16 by a wavy line, and re-emits radiation 18 at a second, longer wavelength. Dye 14 is selected based on the desired wavelength response. Where an infrared reception is desired, dye 14 is preferably selected from the Coumarin family. For wavelength response around 740 nanometers, a dye such as DTTC is selected. DTTC will absorb light around 740 nanometers and re-emit at around 815 nanometers.

The material forming solid 12 should: (a) be at least non-opaque, and preferably transparent, to the radiation to which dye 14 responds; (b) have an index of refraction substantially different from the medium from which the radiation is received; and (c) be capable of being formed such that dye 14 will be suspended therein without chemical or thermal damage. Typical indices of refraction for the media of air and water at room temperature are around 1.00 and 1.33 respectively. With air as the medium, a good index of refraction for the solid 12 is about 1.9. Preferably, the solid is selected from the families of thermoplastics, thermosetting resins, ad epoxy resins.

A receptor 20, preferably a photosensitive semiconductor sensor, is fastened to solid 12 by an adhesive 22, which has an index of refraction substantially similar to that of the material comprising solid 12. Receptor 20 converts radiation 18 re-emitted by dye 14 into electrical current.

The radiation 16 impinges on a collection surface 24 of solid 12. The power in watts received by solid 12 may be expressed as:

$$P_{rec}\ (watts) = I_N \left[ \frac{watts}{cm^2} \right] \cdot H(cm) \cdot L(cm) \tag{1}$$

where: $P_{rec}$ (watts) is the received power

$$I_N \left[ \frac{watts}{cm^2} \right]$$

is the power density of the electromagnetic signal incident to the exposed surface and H(cm) and L(cm) are the dimensions of the exposed collecting surface 24.

The power re-emitted by dye 14 is a percentage of that power received by the antenna. The percentage is based on the actual dye used; for DTTC a 15% re-emission is typical. The re-emitted radiation is at a lower energy level. The relationship between the received and re-emitted power is given by:

$$P_{re\text{-}emitted}\ (watts) = P_{rec}\ (watts) \cdot \%\ re\text{-}emission \tag{2}$$

where: % re-emission is a function of the dye.

That portion of the re-emitted power reaching any surface of solid 12 at an angle greater than the critical angle is internally reflected, and exits another surface if it reaches this other surface at or below the critical angle. The combination of transmission and internal reflection results in an equal amount of power transmitted through each of the six surfaces of the solid. Thus, the power exiting an exit surface 26 is equal to the power exiting the larger collection surface 24, i.e., power concentration has been achieved along a smaller surface area.

When a mirror 28 is deposited or otherwise formed on a surface 30 opposite exit surface 26, the power reflected off that surface is directed downward, into the solid and at least partly out exit surface 26. Exit surface 26 therefore is now emitting 2/6 of the total power re-emitted by the dye. The total power exiting exit surface 26 can be described as:

$$P_{WL}\ (watts) = P_{re\text{-}emitted}\ (watts) \cdot R \tag{3}$$

4

$$= I_N \left[\frac{\text{watts}}{\text{cm}^2}\right] \cdot H(\text{cm}) \cdot L(\text{cm}) \cdot \% \text{ re-emission} \cdot k$$

where: $P_{WL}$ (watts) is the power transmitted through exit surface 26 and
k: constant = 1/6 if no mirror used or 2/6 if a mirror used.

Now that the power emitted through exit surface 26 has been enhanced, a photosensitive semiconductor sensor 20 with a typical efficiency of between .93 and .95 amps/watt, may be placed adjacent to the exit surface 26. The current created in sensor 20 as a result of the power exiting exit surface 26 of solid 12 is expressed as:

$I_a$ (amps) = Efficiency (amp/watts) . $P_{w1}$(watts)     (4)

$$= \text{Efficiency (amp/watts)} \cdot I_N \left[\frac{\text{watts}}{\text{cm}^2}\right] \cdot k \cdot$$

$$\% \text{ re-emission} \cdot H(\text{cm}) \cdot L(\text{cm})$$

where: $I_a$ (amps) is the current produced by the sensor with the antenna, and
Efficiency (amp/watts) is the efficiency of the sensor.

This current may be compared to the current created in the sensor when no antenna is attached, which is directly proportional to the light directly incident on the surface of the sensor itself:

$$I_{WO} \text{ (amps)} = \text{Efficiency} \cdot I_N \left[\frac{\text{watts}}{\text{cm}^2}\right] \cdot W(\text{cm}) \cdot L(\text{cm}) \quad (5)$$

where: $I_{wo}$ is the current produced by the sensor without the antenna, and
W(cm), L(cm) are the dimensions of the sensor receptive surface

The primary difference between the two currents, with and without the antenna, is that with the antenna, the current is proportional to the area of solid collecting face 24, and without the antenna, the current is proportional to the area of the face of receptor 20. This is critical when receptor 20 is a photosensitive pn junction diode, since increasing the width of the exposed face of receptor 20 also increases noise, because the noise is directly proportional to the leakage or dark current, which in turn is directly proportional to the surface area of the exposed face of the semiconductor sensor. Thus, noise can be kept to a minimum and signal current increased by increasing the exposed area of the solid while concurrently keeping the surface area of the sensor small. A principal advantage of this invention can be seen by making a comparison of the signal to noise ratio with and without the antenna. Equation 6 describes the signal to noise ratio of the sensor with the optical antenna attached:

$$\frac{S}{N} = \frac{I \ (\text{amps})}{\text{noise (amps)}} \quad (6)$$

$$= \frac{\text{Efficiency (amp/watts)} \cdot I_N \ (\text{watts/cm}^2) \cdot H(\text{cm}) \cdot L(\text{cm}) \ K \cdot \& \text{ re-emission}}{I_{\text{leakage}} \ (\text{amps/cm}^2) \cdot W(\text{cm}) \cdot L(\text{cm})}$$

where:

$$\frac{S_{\textrm{a}}}{N_{\textrm{a}}}$$

is the signal to noise ratio with the antenna.

$I_{leakage}$ (amps/cm$^2$) is the leakage current over the sensor receptive face.

Equation 7 describes the signal to noise ratio of the sensor without the optical antenna attached.

$$\frac{S_{wo}}{N_{wo}} = \frac{I_{wo} \ (amps)}{Noise \ (amps)} \tag{7}$$

$$= \frac{Efficiency \ (amp/watts) \cdot I_N \ (watts/cm) \cdot w(cm) \cdot L(cm)}{I_{leakage} \ (amps/cm^2) \cdot W(cm) \cdot L(cm)}$$

where:

$$\frac{S_{wo}}{N_{wo}}$$

is the signal to noise ratio without the antenna.

Therefore, the improvement in signal to noise ratio can be described by equation 8, which is the ratio of the signal to noise ratio with the antenna to the signal to noise ratio without the antenna:

$$Improvement \ factor = \frac{S_a/N_a}{S_{wo}/N_{wo}} \tag{8}$$

$$= \frac{k \cdot \% \ re\text{-}emission \cdot H(cm)}{W(cm)}$$

As equation 8 indicates, the signal to noise ratio is directly dependent on the dimensions h and w of the antenna. If h is selected to be much larger than w (e.g., on the order of at least 20 times larger), a significant improvement of the signal to noise ratio can be achieved. The improvement in signal to noise ratio will allow an increase in detection range, which is another significant advantage of this invention.

In summary, an electromagnetic radiation antenna has been described wherein the electromagnetic radiation 16 is received across larger collecting surface 24, absorbed and re-emitted by dye 14, and a portion of the re-emitted radiation 18 transmitted through smaller exit surface 26. By selecting the height of collecting surface 24 to be at least 20 times larger than the width of exit surface 26, significant power concentration across the smaller exit surface 26 is achieved. Further concentration can be achieved, by creating a mirror 28, disposed redirect power back into solid 12, on surface 30 opposite to exit surface 26. The concentration of power along smaller exit surface 26, allows the exposed surface area of receptor 20 to be minimized, which in turn reduces noise. Reduced noise and increased signal power results in an improved signal to noise ratio; an improved signal to noise ratio will allow an increase in detection range or improved reception over a fixed distance. Thus, the invention provides significant advantages in that the signal quality can be improved over a fixed range or the detection range can be increased.

While a preferred embodiment of the present invention and its advantages have been described in the above detailed description, the invention is not limited thereto but only by the scope and spirit of the appended claims.

**Claims**

1. Apparatus for collecting and concentrating electromagnetic radiation transmitted through a medium comprising:

a solid non-opaque to said radiation having an index of refraction for said radiation substantially greater than the medium;

a dye suspended in said solid for re-emitting second radiation in response to receiving said electromagnetic radiation;

an exit face of said solid formed for transmitting second radiation out of said solid; and

a receptor mounted adjacent to said exit face for receiving a predetermined portion of said second radiation.

2. The apparatus of Claim 1, and further comprising at least one mirrored surface of said solid for redirecting a portion of said second radiation back into the interior of said solid.

3. The apparatus of Claim 1, and further comprising an entrance face of said solid for receiving said electromagnetic radiation and at least one mirrored surface of said solid for redirecting a portion of said second radiation back into the interior of said solid.

4. The apparatus of Claim 1, wherein said electromagnetic radiation is selected from the wave band consisting of the infrared, visible and ultraviolet portions of the electromagnetic spectrum.

5. The apparatus of Claim 1, wherein said solid is a polygonal solid.

6. The apparatus of Claim 5, wherein said solid is a rectangular solid.

7. The apparatus of Claim 6, and further comprising an entrance face perpendicular to said exit face.

8. The apparatus of Claim 7, and further comprising a mirrored face perpendicular to said entrance face.

9. The apparatus of Claim 7, wherein said entrance face has a height and a length, said exit face having said length and a width, said height being at least 20 times greater than said width.

10. The apparatus of Claim 1, and further comprising an adhesive for joining said receptor to said exit face, said adhesive having an index of refraction substantially similar to the index of refraction of said solid.

11. Apparatus for collecting and concentrating an electromagnetic signal having a wavelength selected from the infrared, optical and ultraviolet portions of the spectrum, the signal conveyed in a medium, the apparatus comprising:

a dye for absorbing electromagnetic radiation of the wavelength of said electromagnetic signal and for re-emitting radiation in response;

a transparent rectangular solid having an index cf refraction substantially different from said medium, for suspending said dye; and

a receptor mounted adjacent said exit face for receiving a portion of the re-emitted radiation, said receptor sensitive to the re-emission wavelength of said dye.

12. The apparatus of Claim 11, further comprising an entrance face perpendicular to said exit face, a mirrored face parallel to said exit face for redirecting re-emitted radiation towards said exit face.

13. The apparatus of Claim 12, wherein said entrance face has a height and a length, said exit face having said length and a width, said height being at least 20 times greater than said width.

14. The apparatus of Claim 11, wherein said receptor comprises a photosensitive pn junction diode, surface dimensions of said receptor being substantially similar to corresponding dimensions of said exit face.

15. Apparatus for collecting and concentrating an electromagnetic signal consisting of one or more wavelengths selected from the infrared, optical and ultraviolet portions of the electromagnetic spectrum, the signal conveyed in a medium, the apparatus comprising:

a Coumarin dye for absorbing electromagnetic radiation of the wavelength of said electromagnetic signal, and for re-emitting radiation in response;

a transparent solid having an index of refraction substantially different from said medium for suspending said dye, said solid selected from the group consisting of thermoplastics, thermosetting resins and epoxy resins; and

an exit surface of said solid formed at a non-perpendicular angle to the angle of incidence cf the electromagnetic signal on said solid.

16. The apparatus of Claim 15, and further comprising an entrance face of said solid for receiving said electromagnetic signal, and at least one mirrored surface of said solid formed at a non-perpendicular angle to said exit surface, said mirrored surface disposed to redirect a portion of said re-emitted electromagnetic signal back into the interior of said solid.

17. The apparatus of Claim 15, and further comprising an entrance face of said solid perpendicular to said exit face, said solid configured as a rectangular solid.

18. The apparatus of Claim 17, wherein said entrance has a height and a length, said exit face having said length and a width, said height being at least 20 times greater than said width.

19. The apparatus of Claim 18, and further comprising a mirror created on the face of said solid parallel to said exit face.

20. A method for collecting and concentrating electromagnetic radiation travelling in a medium, comprising the steps of:

collecting the signal into a solid non-opaque to the radiation and having an index of refraction substantially different from the medium;

absorbing the radiation by a dye suspended in the solid;

re-emitting a second radiation by the dye in response to said step of absorbing;

transmitting the re-emitted radiation through an exit surface of said solid; and

receiving the re-emitted radiation using a receptor sensitive to the wavelength of said re-emitted radiation.

21. The method of Claim 20, and further comprising the step of using a mirrored surface of the solid to redirect re-emitted radiation back into the solid.

22. A method for receiving an electromagnetic signal traveling in a medium, comprising the steps of:

receiving the signal into an entrance face of a rectangular solid non-opaque to the signal and having an index of refraction substantially different from the medium;

absorbing the signal by a dye suspended in the solid;

re-emitting a second signal by the dye in response to said step of absorbing;

transmitting the second signal through an exit face perpendicular to the entrance face; and

receiving the transmitted second signal using a receptor mounted adjacent to the exit face, the receptor sensitive to the wavelength of said re-emitted radiation.

23. The method of Claim 22, and further comprising the step of using a mirrored surface created on a face of the solid parallel to the exit face to redirect re-emitted radiation back into the interior of the solid.

24. The method of Claim 22, and further comprising the step of configuring said solid such that the entrance face has a height and a length, said exit face having said length and a width, said height being at least 20 times greater than said width.